(19) Europäisches Patentamt
European Patent Office
Office européen des brevets

(11) EP 4 195 264 A1

(12) # EUROPEAN PATENT APPLICATION
published in accordance with Art. 153(4) EPC

(43) Date of publication:
**14.06.2023 Bulletin 2023/24**

(21) Application number: **21866798.8**

(22) Date of filing: **08.09.2021**

(51) International Patent Classification (IPC):
***H01L 25/065*** *(2023.01)* ***H01L 25/07*** *(2006.01)*
***H01L 25/18*** *(2023.01)* ***H01L 21/312*** *(2006.01)*

(52) Cooperative Patent Classification (CPC):
**H01L 21/31; H01L 25/065; H01L 25/07; H01L 25/18**

(86) International application number:
**PCT/JP2021/033032**

(87) International publication number:
**WO 2022/054839 (17.03.2022 Gazette 2022/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.09.2020 JP 2020152329**

(71) Applicant: **Mitsui Chemicals, Inc.**
**Tokyo 104-0028 (JP)**

(72) Inventors:
- **NAKAMURA, Yuzo**
  **Sodegaura-shi, Chiba 299-0265 (JP)**
- **KAYABA, Yasuhisa**
  **Sodegaura-shi, Chiba 299-0265 (JP)**
- **KAMADA, Jun**
  **Sodegaura-shi, Chiba 299-0265 (JP)**

(74) Representative: **Hoffmann Eitle**
**Patent- und Rechtsanwälte PartmbB**
**Arabellastraße 30**
**81925 München (DE)**

## (54) COMPOSITION, MULTILAYER BODY AND METHOD FOR PRODUCING MULTILAYER BODY

(57) A composition, comprising: a compound (A), having an Si-O bond and a cationic functional group that includes at least one selected from the group consisting of a primary nitrogen atom and a secondary nitrogen atom; a compound (B), having at least three -C(=O)OX groups, wherein X is a hydrogen atom or an alkyl group with a carbon number of from 1 to 6, and from one to six of the -C(=O)OX groups is a -C(=O)OH group; and a compound (C), having a cyclic structure and at least one primary nitrogen atom that is directly bonded to the cyclic structure, the composition having a percentage of the primary nitrogen atom and the secondary nitrogen atom in the compound (A), with respect to a total amount of the primary nitrogen atom and the secondary nitrogen atom in the compound (A) and the primary nitrogen atom in the compound (C), of from 3 mol% to 95 mol%.

EP 4 195 264 A1

## Description

[Technical Field]

The present invention relates to a composition, a multilayer body, and a method for producing a multilayer body.

[Background Art]

The further development of integration technologies for elements such as semiconductor chips is required in view of the rising demand for reduction in size and weight and enhanced performance of electronic devices. However, the miniaturization of circuits is insufficient as a solution to meet these demands. Therefore, a technique has been proposed for increasing the level of integration by laminating multiple substrates (wafers) and elements such as semiconductors in a vertical manner to form a multilayer three-dimensional structure.

As the method for laminating the substrates (wafers) or chips (hereinafter, also referred to as "the substrate or the like"), a method of directly bonding the substrates (fusion bonding) and a method of bonding the substrates with an adhesive have been proposed.

The details of the method are found, for example, in Japanese Patent Application Laid-Open (JP-A) No. H04-132258, JP-A No. 2010-226060, JP-A No. 2016-47895, A. Bayrashev, B. Ziaie, Sensors and Actuators A 103 (2003) 16-22, and Q. Y. Tong, U. M. Gosele, Advanced Material 11, No. 17 (1999) 1409-1425.

[Summary of the Invention]

[Problem to be Solved by the Invention]

The method of bonding the substrates with an adhesive is advantageous in that the substrates are bonded at a lower temperature than in the case of fusion bonding, but there are concerns that strain stemming from a difference in the thermal expansion coefficients of an adhesive and a substrate may cause warpage or separation of the substrates. While the thermal expansion coefficient of the adhesive could be lowered by addition of an inorganic filler, the adhesion strength of the adhesive might also be lowered. Therefore, development of a material having both a low thermal expansion coefficient and a higher adhesive strength is desired.

In view of the foregoing, an embodiment of the present invention is to provide a composition that has a low thermal expansion coefficient and exhibits excellent adhesive strength with respect to a substrate; a multilayer body obtained by using the composition; and a method for producing a multilayer body using the composition.

[Means for Solving the Problem]

The specific means for solving the problem includes the following embodiments.

<1> A composition, comprising:

a compound (A), having an Si-O bond and a cationic functional group that includes at least one selected from the group consisting of a primary nitrogen atom and a secondary nitrogen atom;
a compound (B), having at least three -C(=O)OX groups, wherein X is a hydrogen atom or an alkyl group with a carbon number of from 1 to 6, and from one to six of the -C(=O)OX groups is a -C(=O)OH group; and
a compound (C), having a cyclic structure and at least one primary nitrogen atom that is directly bonded to the cyclic structure,
the composition having a percentage of the primary nitrogen atom and the secondary nitrogen atom in the compound (A), with respect to a total amount of the primary nitrogen atom and the secondary nitrogen atom in the compound (A) and the primary nitrogen atom in the compound (C), of from 3 mol% to 95 mol%.

<2> The composition according to <1>, wherein the compound (C) has two or more primary nitrogen atoms that are directly bonded to the cyclic structure.
<3> The composition according to <1> or <2>, wherein the compound (C) has a weight average molecular weight of from 80 to 600.
<4> The composition according to any one of <1> to <3>, wherein the compound (A) has two alkyl groups that are bonded to an oxygen atom in the Si-O bond.
<5> The composition according to any one of <1> to <4>, wherein the compound (B) has a weight average molecular weight of from 200 to 600.

<6> The composition according to any one of <1> to <5>, further comprising a polar solvent.
<7> The composition according to any one of <1> to <6>, which is used for producing a semiconductor device.
<8> The composition according to any one of <1> to <7>, which is used for forming a layer on a substrate or between substrates.
<9> A multilayer body comprising a substrate and a layer, the layer comprising a reaction product of:

a compound (A), having an Si-O bond and a cationic functional group that includes at least one selected from the group consisting of a primary nitrogen atom and a secondary nitrogen atom;
a compound (B), having at least three -C(=O)OX groups, wherein X is a hydrogen atom or an alkyl group with a carbon number of from 1 to 6, and from one to six of the -C(=O)OX groups is a -C(=O)OH group; and
a compound (C), having a cyclic structure and at least one primary nitrogen atom that is directly bonded to the cyclic structure,
the layer having a percentage of the primary nitrogen atom and the secondary nitrogen atom in the compound (A), with respect to a total amount of the primary nitrogen atom and the secondary nitrogen atom in the compound (A) and the primary nitrogen atom in the compound (C), of from 3 mol% to 95 mol%.

<10> The multilayer body according to <9>, wherein the substrate comprises a first substrate and a second substrate, and the first substrate, the layer comprising the reaction product, and the second substrate are disposed in this order.
<11> A method for producing a multilayer body, the method comprising forming a layer on a substrate or between substrates and curing the layer, the layer comprising:

a compound (A), having an Si-O bond and a cationic functional group that includes at least one selected from the group consisting of a primary nitrogen atom and a secondary nitrogen atom;
a compound (B), having at least three -C(=O)OX groups, wherein X is a hydrogen atom or an alkyl group with a carbon number of from 1 to 6, and from one to six of the -C(=O)OX groups is a -C(=O)OH group; and
a compound (C), having a cyclic structure and at least one primary nitrogen atom that is directly bonded to the cyclic structure,
the layer having a percentage of the primary nitrogen atom and the secondary nitrogen atom in the compound (A), with respect to a total amount of the primary nitrogen atom and the secondary nitrogen atom in the compound (A) and the primary nitrogen atom in the compound (C), of from 3 mol% to 95 mol%.

[Effect of the Invention]

According to an embodiment of the present application, a composition that has a low thermal expansion coefficient and exhibits excellent adhesive strength with respect to a substrate; a multilayer body obtained by using the composition; and a method for producing a multilayer body using the composition are provided.

[Embodiments for Implementing the Invention]

In the present disclosure, any numerical range described using the expression "from * to" represents a range in which numerical values described before and after the "to" are included in the range as a minimum value and a maximum value, respectively.
In a numerical range described in stages, in the present disclosure, an upper limit value or a lower limit value described in one numerical range may be replaced with an upper limit value or a lower limit value in another numerical range described in stages. Further, in a numerical range described in the present disclosure, the upper limit value or the lower limit value in the numerical range may be replaced with a value shown in the Examples.

<Composition>

The composition according to the present embodiment is a composition, comprising:

a compound (A), having an Si-O bond and a cationic functional group that includes at least one selected from the group consisting of a primary nitrogen atom and a secondary nitrogen atom;
a compound (B), having at least three -C(=O)OX groups, wherein X is a hydrogen atom or an alkyl group with a carbon number of from 1 to 6, and from one to six of the -C(=O)OX groups is a -C(=O)OH group; and
a compound (C), having a cyclic structure and at least one primary nitrogen atom that is directly bonded to the cyclic structure,
the composition having a percentage of the primary nitrogen atom and the secondary nitrogen atom in the compound

(A), with respect to a total amount of the primary nitrogen atom and the secondary nitrogen atom in the compound (A) and the primary nitrogen atom in the compound (C), of from 3 mol% to 95 mol%.

The composition includes, as a component that reacts with a compound (B), a compound (A) and a compound (C). The studies made by the present inventors have revealed that a cured product obtained from the composition has a lower thermal expansion coefficient as compared with a cured composition obtained from a composition that includes, as a component that reacts with a compound (B), a compound (A) alone. Therefore, it is thought that strain is less likely to occur at an interface between a layer formed from the composition and a substrate, and therefore the multilayer body exhibits favorable reliability.
Further, the layer obtained from the composition exhibits favorable adhesive strength with respect to the substrate.

(Compound (A))

The compound (A) has an Si-O bond and a cationic functional group that includes at least one selected from the group consisting of a primary nitrogen atom and a secondary nitrogen atom.
The cationic functional group may be positively charged, and is not particularly limited as long as it is a functional group that includes at least one selected from the group consisting of a primary nitrogen atom and a secondary nitrogen atom.
The cationic functional group that includes at least one selected from the group consisting of a primary nitrogen atom and a secondary nitrogen atom reacts with a carboxy group of the compound (B) and forms a cured product. The Si-O bond of the compound (A) contributes to an improvement in the adhesive strength with respect to a substrate.
The composition may include a single kind of the compound (A), or may include two or more kinds thereof in combination.
The compound (A) may include a tertiary nitrogen atom, in addition to primary and secondary nitrogen atoms.
In the present disclosure, the "primary nitrogen atom" refers to a nitrogen atom that is bonded to two hydrogen atoms and one atom other than a hydrogen atom, for example, a nitrogen atom included in a primary amino group ($-NH_2$) or a nitrogen atom that is bonded to three hydrogen atoms and one atom other than a hydrogen atom (cation).

the "secondary nitrogen atom" refers to a nitrogen atom that is bonded to one hydrogen atoms and two atoms other than a hydrogen atom, i.e., a nitrogen atom in a functional group represented by the following Formula (a), or a nitrogen atom that is bonded to two hydrogen atoms and two atoms other than a hydrogen atom (cation).
the "tertiary nitrogen atom" refers to a nitrogen atom that is bonded to three atoms other than a hydrogen atom, i.e., a nitrogen atom in a functional group represented by the following Formula (b), or a nitrogen atom that is bonded to one hydrogen atom and three atoms other than a hydrogen atom (cation).

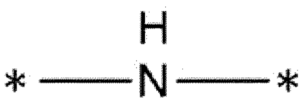 (a)

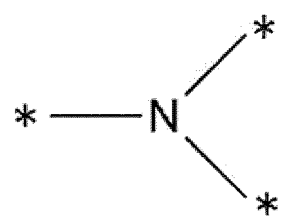 (b)

In Formula (a) and Formula (b), the asterisk * refers to a bonding site with an atom other than a hydrogen atom.
The functional group represented by Formula (a) may be a functional group that constitutes a part of secondary amino group ($-NHR^a$; wherein $R^a$ represents an alkyl group) or may be a divalent linking group in a polymer skeleton.
The functional group represented by Formula (b), i.e., a tertiary nitrogen atom, may be a functional group that constitutes a part of tertiary amino group ($-NHR^bR^c$; wherein each of $R^b$ and $R^c$ independently represents an alkyl group) or may be a trivalent linking group in a polymer skeleton.
From the viewpoint of reducing a degree of water absorption of a cured product and reducing the amount of outgas, the compound (A) preferably has two alkyl groups being bonded to an oxygen atom in an Si-O bond, more preferably two alkyl groups being bonded to two oxygen atoms that are bonded to one silicon atom in an Si-O bond, respectively. The carbon number of the two alkyl groups is preferably independently from 1 to 5, more preferably 1 or 2, further preferably 2.
The weight average molecular weight of the compound (A) is not particularly limited, and may be any one of from 130 to 10000, from 130 to 5000, or from 130 to 2000, for example.
In the present disclosure, the weight average molecular weight of a compound is a polyethylene glycol-converted

weight average molecular weight measured by GPC (Gel Permeation Chromatography).

Specifically, the weight average molecular weight is calculated from a refraction index using polyethylene glycol/polyethylene oxide as a standard and an analysis software (Empower 3, Waters). The refraction index is measured using a sodium nitrate aqueous solution (0.1 mol/L) as a developing solvent, and Shodex DET RI-101 as an analyzer and two analysis columns (TSKgel G6000PWXL-CP and TSKgel G3000PWXL-CP) at a flow rate of 1.0 mL/min.

The compound (A) may further have an anionic functional group or a nonionic functional group, as necessary.

The nonionic functional group may be a hydrogen-bond receptor or a hydrogen-bond donor. Specific examples of the nonionic functional group include a hydroxy group, a carbonyl group and an ether group (-O-).

The anionic functional group is not particularly limited, as long as it can be negatively charged. Specific examples of the anionic functional group include a carboxy group, a sulfonate group and a sulfate group.

Specific example of the compound (A) include a compound having an Si-O bond and an amino group, and examples thereof include a siloxanediamine, a silane coupling agent having an amino group, and a siloxane polymer obtained from a silane coupling agent having an amino group.

Specific example of the silane coupling agent having an amino group include a compound represented by the following Formula (A-3).

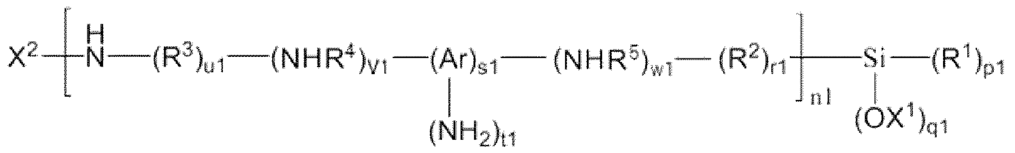

(A-3)

p1=0-2, q1=1-3, n1=1-3, r1=0-1, s1=0-1, t1=0-1, u1=0-1, v1=0-1 ,w1=0-1 , p1+q1=3

In Formula (A-3), $R^1$ represents an alkyl group of 1 to 4 carbon atoms that may be substituted. Each of $R^2$ and $R^3$ independently represents an alkylene group of 1 to 12 carbon atoms that may be substituted (there may be a carbonyl group, an ether group or the like in a skeleton), an ether group or a carbonyl group. Each of $R^4$ or $R^5$ independently represents a single bond or an alkylene group of 1 to 4 carbon atoms that may be substituted. Ar represents a divalent or trivalent aromatic ring. $X^1$ represents a hydrogen atom or an alkyl group of 1 to 5 carbon atoms that may be substituted. $X^2$ represents a hydrogen atom, a cycloalkyl group, a heterocyclic group, an aryl group or an alkyl group of 1 to 5 carbon atoms that may be substituted (there may be a carbonyl group, an ether group or the like in a skeleton). When there are two or more of $R^1$, $R^2$, $R^3$, $R^4$, $R^5$ or $X^1$, the two or more of $R^1$, $R^2$, $R^3$, $R^4$, $R^5$ or $X^1$ may be the same or different from each other.

Example of a substituent of the alkyl group or the alkylene group represented by $R^1$, $R^2$, $R^3$, $R^4$, $R^5$, $X^1$ or $X^2$ include an amino group, a hydroxy group, an alkoxy group, a cyano group, a carboxy group, a sulfonate group or a halogen atom.

Example of the divalent or trivalent aromatic ring in Ar include a divalent or trivalent benzene ring. Examples of the aryl group in $X^2$ include a phenyl group, a methylbenzyl group and a vinylbenzyl group.

Specific examples of the silane coupling agent represented by Formula (A-3) include N-(2-aminoethyl)-3-aminopropylmethyldiethoxysilane, N-(2-aminoethyl)-3-aminopropyltriethoxysilane, N-(2-aminoethyl)-3-aminoisobutyldimethylmethoxysilane, N-(2-aminoethyl)-3-aminoisobutylmethyldimethoxysilane, N-(2-aminoethyl)-11-aminoundecyltrimethoxysilane, 3-aminopropyltrimethoxysilane, 3-aminopropyltriethoxysilane, N-phenyl-3-aminopropyltrimethoxysilane, (aminoethylaminoethyl)phenyltriethoxysilane, methylbenzylaminoethylaminopropyltrimethoxysilane, benzylaminoethylaminopropyltriethoxysilane, 3-ureidopropyltriethoxysilane, (aminoethylaminoethyl)phenethyltrimethoxysilane, (aminoethylaminomethyl)phenetyltrimethoxysilane, N-[2-[3-(trimethoxysilyl)propylamino]ethyl]ethylenediamine, 3-aminopropyldiethoxymethylsilane, 3-aminopropyldimethoxymethylsilane, 3-aminopropyldimethylethoxysilane, 3-aminopropyldimethylmethoxysilane, trimethoxy[2-(2-aminoethyl)-3-aminopropyl]silane, diaminomethylmethyldiethoxysilane, methylaminomethylmethyldiethoxysilane, p-aminophenyltrimethoxysilane, N-methylaminopropyltriethoxysilane, N-methylaminopropylmethyldiethoxysilane, (phenylaminomethyl)methyldiethoxysilane, acetamidepropyltrimethoxysilane, and hydrolysates thereof.

Examples of the silane coupling agent including an amino group other than that represented by Formula (A-3) include N,N-bis[3-(trimethoxysilyl)propyl]ethylenediamine, N,N'-bis[3-(trimethoxysilyl)propyl]ethylenediamine, bis[3-triethoxysilyl)propyl]amine, piperazinylpropylmethyldimethoxysilane, bis[3-(triethoxysilyl)propyl]urea, bis(methyldiethoxysilylpropyl)amine, 2,2-dimethoxy-1,6-diaza-2-silacyclooctane, 3,5-diamino-N-(4-methoxydimethylsilyl)phenyl)benzamide, 3,5-diamino-N-(4-(triethoxysilyl)phenyl)benzamide, 5-(ethoxydimethylsilyl)benzene-1,3-diamine, and hydrolysates of these compounds.

The silane coupling agent having an amino group may be used alone or in combination of two or more kinds.

It is possible to use a siloxane polymer, which is a polymer formed from a silane coupling agent via a siloxane bond (Si-O-Si). For example, a polymer having a linear siloxane structure, a branched siloxane structure, a cyclic siloxane

structure or a basket-like siloxane structure may be formed from a hydrolysate of 3-aminopropyltrimethoxysilane. The basket-like siloxane structure is represented by the following Formula (A-1), for example.

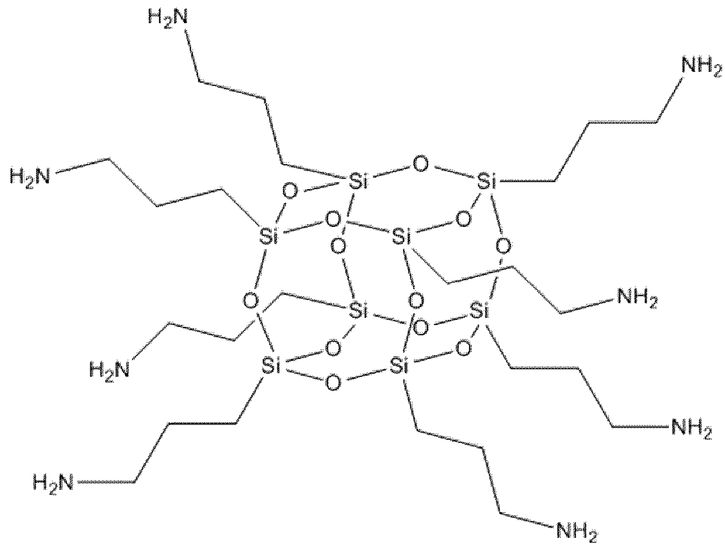

(A-1)

Examples of the siloxane diamine include a compound represented by the following Formula (A-2). In Formula (A-2), i represents an integer of from 0 to 4, j represents an integer of from 1 to 3, and Me represents a methyl group.

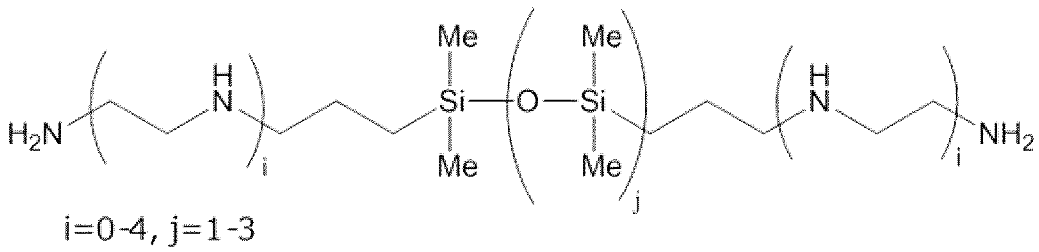

(A-2)

i=0-4, j=1-3

Examples of the siloxane diamine include 1,3-bis(3-aminopropyl)tetramethyldisiloxane, which is a compound represented by Formula (A-2) wherein i is 0 and j is 1; and 1,3-bis(2-aminoethylamino)propyltetramethyldisiloxane, which is a compound represented by Formula (A-2) wherein i is 1 and j is 1.

Since the compound (A) has a cationic functional group including at least one of a primary nitrogen atom or a secondary nitrogen atom, the composition can tightly bond the substrates by means of an electrostatic interaction between the cationic functional group and a functional group that may exist on a surface of the substrate such as a hydroxy group, an epoxy group, a carboxy group, an amino group or a mercapto group, or by means of densely-formed covalent bondings between the cationic group and a functional group as mentioned above.

Further, the compound (A) is highly soluble to a polar solvent because of a cationic functional group including at least one of a primary nitrogen atom or a secondary nitrogen atom. Therefore, the composition is highly compatible to a substrate having a hydrophilic surface such as silicon, and can form a flat film on the substrate.

From the viewpoint of thermal resistivity, the compound (A) is preferably a compound having an amino group as a cationic functional group. In view of improving the thermal resistivity by forming a thermal cross-linking structure such as an amide, amide-imide or imide structure, the compound (A) is preferably a compound having a primary amino group.

The ratio of a total number of the primary nitrogen atom and the secondary nitrogen atom in the compound (A) to a number of silicon atoms in the compound (A) (total number of primary and secondary nitrogen atoms / number of silicon atoms) are not particularly limited. From the viewpoint of forming a flat and thin film, the ratio is preferably from 0.2 to 5.

The compound (A) preferably has a molar ratio of Si element to a non-crosslinkable group such as a methyl group bonded to an Si element (non-crosslinkable group / Si element) of less than 2. In that case, it is thought that the density of a crosslinked structure formed in a film (such as a crosslinked structure formed between an Si-O-Si bond and an amide bond or an imide bond) is improved and excellent bonding strength is achieved.

As previously mentioned, the compound (A) has a cationic functional group including at least one of a primary

nitrogen atom or a secondary nitrogen atom. When the compound (A) includes a primary nitrogen atom, the ratio of the primary nitrogen atom in the total nitrogen atoms in the compound (A) is preferably 20 mol% or more, more preferably 25 mol% or more, further preferably 30 mol% or more. The compound (A) may have a cationic functional group including a primary nitrogen atom but not including a nitrogen atom other than the primary nitrogen atom (such as a primary or tertiary nitrogen atom).

When the ratio of the primary nitrogen atom in the total nitrogen atoms in the compound (A) is 20 mol% or more, it is possible to form a bonding with a functional group that may exist at a surface of a substrate in a dense manner, thereby bonding the substrates more tightly.

When the compound (A) includes a secondary nitrogen atom, the ratio of the secondary nitrogen atom in the total nitrogen atom in the compound (A) is preferably from 5 mol% to 50 mol%, more preferably from 5 mol% to 30 mol%.

The compound (A) may include a tertiary nitrogen atom in addition to a primary or secondary nitrogen atom. When the compound (A) includes a tertiary nitrogen atom, the ratio of the tertiary nitrogen atom in the total nitrogen atoms in the compound (A) is preferably from 20 mol% to 50 mol%, more preferably from 25 mol% to 45 mol%.

The content of the compound (A) in the composition is not particularly limited, as long as the percentage of a primary nitrogen atom and a secondary nitrogen atom in the compound (A), with respect to a total amount of a primary nitrogen atom and a secondary nitrogen atom in the compound (A) and a primary nitrogen atom in the compound (C), is from 3 mol% to 95 mol%.

From the viewpoint of a balance between a thermal expansion coefficient and a bonding strength, the percentage is preferably from 5 mol% to 75 mol%, more preferably from 10 mol% to 50 mol%.

(Compound (B))

The compound (B) is a compound having at least three -C(=O)OX groups in a molecule, wherein X is a hydrogen atom or an alkyl group with a carbon number of from 1 to 6, and from one to six of the -C(=O)OX groups is a -C(=O)OH group.

Hereinafter, the -C(=O)OX group may be referred to as COOX, and the -C(=O)OH group may be referred to as COOH.

When the compound (B) has a -C(=O)OX group in a molecule, wherein X is a hydrogen atom or an alkyl group with a carbon number of from 1 to 6, solubility of the compound (B) in the composition is improved.

The composition may include a single kind of compound (B), or may include two or more kinds thereof in combination.

The compound (B) is preferably a compound having from three to six -C(=O)OX groups in a molecule, more preferably a compound having three or four -C(=O)OX groups in a molecule.

When the compound (B) has three or four -C(=O)OX groups in a molecule, the compound (B) can react with the compound (A) in an efficient manner.

In the compound (B), X in the -C(=O)OX groups may be a hydrogen atom or an alkyl group with a carbon number of from 1 to 6, preferably a hydrogen atom, a methyl group, an ethyl group or a propyl group. The X in the -C(=O)OX groups may be the same or different from each other.

The compound (B) is preferably a compound having from one to four -C(=O)OH groups in a molecule, more preferably from two to four -C(=O)OH groups, further preferably two or three -C(=O)OH groups.

When the compound (B) has from one to four -C(=O)OH groups in a molecule, solubility of the compound (B) in the composition is improved.

The weight average molecular weight of the compound (B) is not particularly limited. For example, the weight average molecular weight of the compound (B) may be any one of from 200 to 600, from 200 to 500, from 200 to 450, or from 200 to 400.

When the weight average molecular weight of the compound (B) is within the above range, solubility of the compound (B) in the composition is improved.

The compound (B) preferably has a cyclic structure in a molecule. Examples of the cyclic structure include an aliphatic ring structure and an aromatic ring structure. The compound (B) may have two or more cyclic structures, and the two or more cyclic structures may be the same or different from each other.

When the compound (B) has a cyclic structure in a molecule, thermal resistance of a cured product of the composition is improved.

The aliphatic ring structure may be an aliphatic ring structure with a carbon number of from 3 to 8, preferably an aliphatic ring structure with a carbon number of from 4 to 6, for example. The aliphatic ring structure may be saturated or unsaturated. Specific examples of the aliphatic structure include saturated aliphatic ring structures such as a cyclopropane ring, a cyclobutane ring, a cyclopentane ring, a cyclohexane ring, a cycloheptane ring and a cyclooctane ring; and unsaturated aliphatic ring structures such as a cyclopropene ring, a cyclobutene ring, a cyclopentene ring, a cyclohexene ring, a cycloheptene ring and a cyclooctene ring.

The aromatic ring structure is not particularly limited, as long as the structure has a nature of aromatic ring. Specific examples of the aromatic ring structure include benzenoid aromatic ring structures such as a benzene ring, a naphthalene ring, an anthracene ring and a perylene ring; heteroaromatic ring structures such as a pyridine ring and a thiophene ring; and non-benzenoid aromatic ring structures such as an indene ring and an azulene ring.

In view of improving the thermal resistance of a cured product, the compound (B) preferably has at least one selected from the group consisting of a cyclobutane ring, a cyclopentane ring, a cylohexane ring, a benzene ring and a naphthalene ring, more preferably at least one of a benzene ring or a naphthalene ring.

As previously mentioned, the compound (B) may have two or more cyclic structure in a molecule. When the cyclic structure is a benzenoid structure, the compound (B) may have a biphenyl structure, a benzophenone structure, a diphenylether structure or the like.

The compound (B) may have a fluorine atom in a molecule. For example, the compound (B) may have from one to six fluorine atoms in a molecule, or may have from three to six fluorine atoms in a molecule. For example, the compound (B) may have a fluoroalkyl group such as a trifluoroalkyl group or a hexafluoroisopropyl group in a molecule.

When the compound (B) has a fluorine atom in a molecule, water absorbability of a cured product is reduced.

Examples of the compound (B) include carboxylic acid compounds such as alicyclic carboxylic acid, benzene carboxylic acid, naphthalene carboxylic acid, diphthalic acid and fluorinated aromatic carboxylic acid; and carboxylic acid ester compounds such as alicyclic carboxylic acid ester, benzene carboxylic acid ester, naphthalene carboxylic acid ester, diphthalic acid ester and fluorinated aromatic carboxylic acid ester.

The carboxylic acid ester compound refers to a compound that has a carboxy group (-C(=O)OH group) and at least one of X in the at least three -C(=O)OX groups being an alkyl group with a carbon number of 1 to 6 (i.e., having an ester bond).

In the present embodiment, when the compound (B) is a carboxylic acid ester compound, formation of an aggregate caused by the association of the compound (A) and the compound (B) is suppressed. Therefore, formation of an aggregate or pits are suppressed, thereby making it easier to adjust a film thickness.

The carboxylic acid compound is preferably a carboxylic acid compound having not more than four -C(=O)OH groups, more preferably a carboxylic acid compound having three or four - C(=O)OH groups.

The carboxylic acid ester compound is preferably a compound having not more than three carboxy groups (-C(=O)OH groups) and not more than three ester bonds in a molecule, more preferably a compound having not more than two carboxy groups (-C(=O)OH groups) and not more than two ester bonds in a molecule.

When the carboxylic acid ester compound has three or more -C(=O)OH groups wherein X is an alkyl group with a carbon number of from 1 to 6, the X is preferably a methyl group, an ethyl group, a propyl group or a butyl group. From the viewpoint of suppressing the formation of an aggregate caused by the association of the compound (A) and the compound (B), X is preferably an ethyl group or a propyl group.

Specific examples of the carboxylic acid compound include aliphatic ring carboxylic acids such as 1,2,3,4-cyclobutane tetracarboxylic acid, 1,2,3,4-cyclopentane tetracarboxylic acid, 1,3,5-cyclohexane tricarboxylic acid, 1,2,4-cyclohexane tricarboxylic acid, 1,2,4,5-cyclohexane tetracarboxylic acid and 1,2,3,4,5,6-cyclohexane hexacarboxylic acid; benzene carboxylic acids such as 1,2,4-benzene tricarboxylic acid, 1,3,5-benzene tricarboxylic acid, pyromellitic acid, benzene pentacarboxylic acid and mellitic acid; naphthalene carboxylic acids such as 1,4,5,8-naphthalene tetracarboxylic acid and 2,3,6,7-naphthalene tetracarboxylic acid; diphthalic acid such as 3,3',5,5'-tetracarboxydiphenylmethane, biphenyl-3,3',5,5'-tetracarboxylic acid, biphenyl-3,4',5-tricarboxylic acid, biphenyl-3,3',4,4'-tetracarboxylic acid, benzophenone-3,3',4,4'-tetracarboxylic acid, 4,4'-oxydiphthalic acid, 3,4'-oxydiphthalic acid, 1,3-bis(phthalic acid)tetramethyldisiloxane, 4,4'-(ethine-1,2-diyl)diphthalic acid, 4,4'-(1,4-phenylenebis(oxy)) diphtalic acid, 4,4'-([1,1'-biphenyl]-4,4'-diylbis(oxy)) diphtalic acid and 4,4'-((oxybis(4,1-phenylene))bis(oxy)) diphthalic acid; perylene carboxylic acids such as perylene-3,4,9,10-tetracarboxylic acid; anthracene carboxylic acids such as anthracene-2,3,6,7-tetracarboxylic acid; and fluorinated aromatic carboxylic acids such as 4,4-(hexafluoroisopropylidene) diphthalic acid, 9,9-bis(trifluoromethyl)-9H-xanthene-2,3,6,7-tetracarbocylic acid and 1,4-di(trifluoromethyl) pyromellitic acid.

Specific examples of the carboxylic acid ester compound include the above-mentioned caboxylic acid compounds in which at least one carboxy group is substituted by an ester group.

Specific examples of the carboxylic acid ester compound include half-esterified carboxylic acid compounds represented by the following Formulas (B-1) to (B-6).

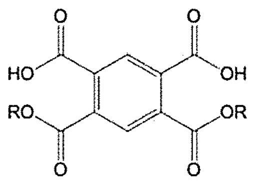
(B-1)

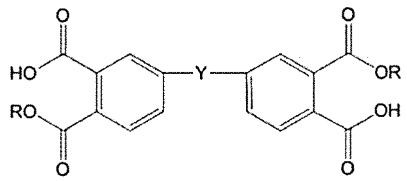
(B-2)

Y = O, C=O, $C(CF_3)_2$

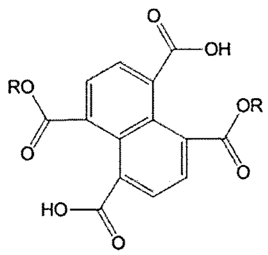
(B-3)

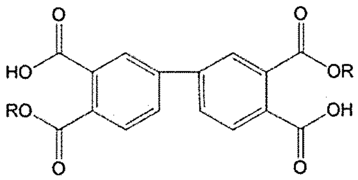
(B-4)

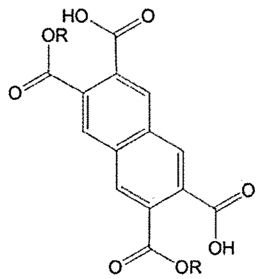
(B-5)

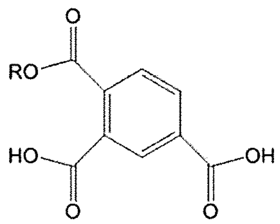
(B-6)

In the Formulas (B-1) to (B-6), each of R independently represents an alkyl group with a carbon number of from 1 to 6, preferably a methyl group, an ethyl group, a propyl group or a butyl group, more preferably an ethyl group or a propyl group.

The half-esterified compound may be obtained by, for example, causing ring-opening of a carboxylic acid anhydride, which is an anhydride of a carboxylic acid compound, by mixing the carboxylic acid anhydride with an alcohol solvent.

The content of the compound (B) in the composition is preferably adjusted such that a ratio of carboxy group equivalent amount (COOH) to amine equivalent amount (N) in the total of the compound (A) and the compound (C) (COOH/N) is from 0.1 to 3.0, more preferably from 0.3 to 2.5, further preferably from 0.4 to 2.2.

When the COOH/N is within a range of from 0.1 to 3.0, a crosslinked structure tends to be formed to a sufficient degree due to the reaction of the compound (A), compound (B) and compound (C), and a cured product with excellent thermal resistance and insulation properties tends to be obtained.

(Compound (C))

The compound (C) is a compound having a cyclic structure and at least one primary nitrogen atom that is directly bonded to the cyclic structure.

Together with the compound (A), the compound (C) reacts with the compound (B) and forms a cured product.

The compound (C) has a cyclic structure and at least one primary nitrogen atom that is directly bonded to the cyclic structure. It is thought that introduction of the structure of the compound (C) into a cured product increases the stiffness and decreases the thermal expansion coefficient of the cured product.

The composition may include a single kind of the compound (C), or may include two or more kinds thereof in combination.

In the present disclosure, the primary nitrogen atom directly bonded to a cyclic structure refers to a primary nitrogen atom ($-NH_2$) that is bonded to a cyclic structure via a single bond, i.e., without interposing a carbon atom or the like.

The number of the primary nitrogen atom directly bonded to a cyclic structure in a molecule of the compound (C) is not particularly limited, as long as the number is one or more. From the viewpoint of increasing a crosslinking density, the compound (C) is preferably a compound having two or more primary nitrogen atoms directly bonded to a

cyclic structure, more preferably a diamine compound having two primary nitrogen atoms or a triamine compound having three primary nitrogen atoms.

The compound (C) may have one cyclic structure or two or more cyclic structures in a molecule. When the compound (C) has two or more cyclic structures in a molecule, each of the cyclic structures may have a cationic functional group including a primary nitrogen atom directly bonded thereto, or any one of the cyclic structures may have a cationic functional group including a primary nitrogen atom directly bonded thereto.

When the compound (C) has two or more cyclic structures in a molecule, the cyclic structures may be the same or different from each other, and the cyclic structures may form a condensed ring. The two or more cyclic structures may be bonded via a single bond or via a linking group such as an ether group, a carbonyl group, a sulfonyl group or a methylene group.

Examples of the cyclic structure in the compound (C) include an aliphatic ring structure, an aromatic ring (including a hetero ring) structure, and a condensed ring structure thereof.

The aliphatic ring structure may be an aliphatic ring structure having a carbon number of from 3 to 8, preferably from 4 to 6. The cyclic structure may be saturated or unsaturated. Specific examples of the aliphatic ring structure include saturated aliphatic ring structures such as a cyclopropane ring, a cyclobutane ring, a cyclopentane ring, a cyclohexane ring, a cycloheptane ring and a cyclooctane ring; and unsaturated aliphatic ring structures such as a cyclopropene ring, a cyclobutene ring, a cyclopentene ring, a cyclohexene ring, a cycloheptene ring and a cyclooctene ring.

The aromatic ring structure may be an aromatic ring structure having a carbon number of from 6 to 20, preferably from 6 to 10. Specific examples of the aromatic ring structure include benzenoid aromatic ring structures such as a benzene ring, a naphthalene ring, an anthracene ring and a perylene ring; and non-benzenoid aromatic ring structures such as a pyridine ring, a thiophene ring, an indene ring and an azulene ring.

The heterocyclic structure may be a heterocyclic structure with a 3 to 10-membered ring, preferably a 5 or 6-membered ring. The heteroatom in the hetero ring include a sulfur atom, a nitrogen atom and an oxygen atom. The heterocyclic structure may include a single kind of heteroatom, or may include two or more kinds thereof in combination.

Specific examples of the heterocyclic structure include an oxazole ring, a thiophene ring, a pyrrol ring, a pyrrolidine ring, a pyrazole ring, an imidazole ring, a triazole ring, an isocyanuric ring, a pyridine ring, a pyridazine ring, a pyrimidine ring, a pyrazine ring, a piperidine ring, a piperazine ring, a triazine ring, an indole ring, an indoline ring, a quinoline ring, an acridine ring, a naphthyridine ring, a quinazoline ring, a purine ring and a quinoxaline ring.

The cyclic structure in the compound (C) is preferably a benzene ring, a cyclohexane ring or a benzoxazole ring.

The cyclic structure in the compound (C) may have a substituent other than a primary nitrogen atom, such as an alkyl group with a carbon number of from 1 to 6 or an alkyl group having a halogen atom as a substituent.

The weight average molecular weight of the compound (C) is not particularly limited. For example, the weight average molecular weight of the compound (C) may be any one of from 80 to 600, from 90 to 500, or from 100 to 450.

The compound (C) may be an alicyclic amine, an aromatic amine, a heterocyclic amine having a hetero ring including a nitrogen atom, and an amine compound having a hetero ring and an aromatic ring.

Specific example of the alicyclic amine include cyclohexylamine and dimethylaminocyclohexane.

Specific examples of the aromatic amine include diaminodiphenyl ether, xylylenediamine (preferably p-xylylenediamine), diaminobenzene, diaminotoluene, methylenedianiline, dimethyldiaminobiphenyl, bis(trifluoromethyl)diaminobiphenyl, diaminobenzophenone, diaminobenzanilide, bis(aminophenyl)fluorene, bis(aminophenoxy)benzene, bis(aminophenoxy)biphenyl, dicarboxydiaminodiphenylmethane, diaminoresorcin, dihydroxybenzidine, diaminobenzidine, 1,3,5-triaminophenoxybenzene, 2,2'-dimethylbenzidine, and tris(4-aminophenyl) amine.

Specific examples of the heterocyclic amine having a nitrogen-containing heterocyclic ring include melamine, ammeline, melam, melem and tris(4-aminophenyl) amine.

Specific examples of the amine compound having a hetero ring and an aromatic ring include N2,N4,N6-tris(4-aminophenyl)-1,3,5-triazine-2,4,6-triamine and 2-(4-aminophenyl)benzoxazole-5-amine.

The content of the compound (C) in the composition is not particularly limited, as long as the percentage of the primary nitrogen atom and the secondary nitrogen atom in the compound (A), with respect to a total amount of the primary nitrogen atom and the secondary nitrogen atom in the compound (A) and the primary nitrogen atom in the compound (C), is from 3 mol% to 95 mol%.

From the viewpoint of a balance between the thermal expansion coefficient and the bonding strength, the percentage is preferably from 5 mol% to 75 mol%, more preferably from 10 mol% to 50 mol%, further preferably from 10 mol% to 30 mol%.

(Polar solvent)

The composition may include a polar solvent. In the present disclosure, the polar solvent refers to a solvent having a specific permittivity of 5 or more at room temperature (25°C).

By including a polar solvent in the composition, solubility of the components in the composition is improved.

The composition may include a single kind of a polar solvent, or may include two or more kinds thereof in combination.

Specific examples of the polar solvent include protic solvents such as water and heavy water; alcohols such as methanol, ethanol, 1-propanol, 2-propanol, 1-butanol, 2-butanol, isobutyl alcohol, isopentyl alcohol, cyclohexanol, ethylene glycol, propylene glycol, 2-methoxyethanol, 2-ethoxyethanol, benzyl alcohol, diethylene glycol, triethylene glycol and glycerin; ethers such as tetrahydrofuran and dimethoxyethane; aldehydes or ketones such as furfural, acetone, ethyl methyl ketone and cyclohexanone; acid derivatives such as acetic anhydride, ethyl acetate, butyl acetate, ethylene carbonate, propylene carbonate, formaldehyde, N-methylformamide, N,N-dimethylformamide, N-methylacetamide, N,N-dimethylacetamide, N-methyl-2-pyrrolidone and hexamethylphosphoramide; nitriles such as acetonitrile and propionitrile; nitro compounds such as nitromethane and nitrobenzene; and sulfur compounds such as dimethylsulfoxide.

The polar solvent is preferably a protic solvent, more preferably water, further preferably ultra-pure water.

When the composition includes a polar solvent, the content thereof is not particularly limited. For example, the content of the polar solvent with respect to the total amount of the composition may be from 1.0% by mass to 99.99896% by mass, or may be from 40% by mass to 99.99896% by mass.

(Additive)

The composition may include an additive, as necessary. Examples of the additive include an acid having a carboxy group with a weight average molecular weight of from 46 to 195 and a base having a nitrogen atom and not having a cyclic structure with a weight average molecular weight of from 17 to 120.

When the composition includes an acid having a carboxy group with a weight average molecular weight of from 46 to 195, it is thought that the carboxy group of the acid forms an ionic bond with a primary or secondary nitrogen atom in the compound (A) or the compound (C), thereby suppressing the aggregation due to the association of the compound (A) and the compound (C) with the compound (B). More specifically, it is thought that the aggregation is suppressed because an interaction (such as electrostatic interaction) of an ammonium ion derived from the compound (A) and the compound (C) with a carboxylate ion derived from a carboxy group of the acid is stronger than an interaction with a carboxylate ion derived from a carboxy group of the compound (B). It is noted that the present invention is not limited to this hypothesis.

The type of the acid having a carboxy group with a weight average molecular weight of from 46 to 195 is not particularly limited, and may be a monocarboxylic acid, a dicarboxylic acid or an oxydicarboxylic acid, for example.

Specific examples of the acid (except for a compound corresponding to the compound (B)) include formic acid, acetic acid, malonic acid, oxalic acid, benzoic acid, lactic acid, glycolic acid, glyceric acid, butyric acid, methoxyacetic acid, ethoxyacetic acid, phthalic acid, terephthalic acid, picolinic acid, salicylic acid and 3,4,5-trihydroxybenzoic acid.

The content of the acid having a carboxy group with a weight average molecular weight of from 46 to 195 in the composition is not particularly limited. For example, the content of the acid is preferably determined such that a ratio of the number of carboxy groups in the acid to the total number of nitrogen atoms in the compound (A) and the compound (C) (COOH/N) is from 0.01 to 10, more preferably from 0.02 to 6, further preferably from 0.5 to 3.

When the composition includes a base having a nitrogen atom with a weight average molecular weight of from 17 to 120, it is thought that the carboxy group of the compound (B) forms an ionic bond with an amino group of the base, thereby suppressing the aggregation due to the association of the compound (A) and the compound (C) with the compound (B). More specifically, it is thought that the aggregation is suppressed because an interaction of a carboxylate ion derived from a carboxy group of the compound (B) with an ammonium ion derived from the amino group of the base is stronger than an interaction with an ammonium ion derived from the compound (A) and the compound (C). It is noted that the present invention is not limited to this hypothesis.

The type of the base having a nitrogen atom with a weight average molecular weight of from 17 to 120 is not particularly limited, and may be a monoamine compound, a diamine compound or the like, for example.

Specific examples of the base (except for a compound corresponding to the compound (A) or the compound (C)) include ammonia, ethylamine, ethanolamine, diethylamine, triethylamine, ethylenediamine, N-acetylethylenediamine, N-(2-aminoethyl) ethanolamine and N-(2-aminoethyl) glycine.

The content of the base with a weight average molecular weight of from 17 to 120 in the composition is not particularly limited. For example, the content of the base is preferably determined such that a ratio of the number of nitrogen atoms in the base to the number of carboxy groups in the compound (B) (N/COOH) is from 0.5 to 5, more preferably from 0.9 to 3.

(Other components)

When the composition needs to have selectivity to plasma-etching resistance (for example, when the composition is used as a gap-fill material or as an embedded insulation film), the composition may include a metal alkoxide

represented by the following Formula (I).

Formula (I) $R1_nM(OR2)_{m-n}$

In Formula (I), R1 represents a non-hydrolyzable group; R2 represents an alkyl group with a carbon number of from 1 to 6; M represents at least one metal atom selected from Ti, Al, Zr, Sr, Ba, Zn, B, Ga, Y, Ge, Pb, P, Sb, V, Ta, W, La, Nd and In; n is a number of valency of metal atom represented by M which is 3 or 4; n is an integer of 0 to 2 when m is 4, or an integer of 0 or 1 when m is 3. When there are two or more of $R^1$, the two or more of R1 may be the same or different from each other. When there are two or more of OR2, the two or more of OR2 may be the same or different from each other.

When a film formed from the composition needs to be insulative (such as an insulation film for through-silicon via or an embedded insulation film), the composition may include a silane compound (except for a compound corresponding to the compound (A)) for improving the insulation properties or the mechanical strength.

Specific examples of the silane compound include tetraethoxysilane, tetramethoxysilane, bistriethoxysilylethane, bistriethoxysilylmethane, bis(methyldiethoxysilyl)ethane, 1,1,3,3,5,5-hexaethoxy-1,3,5-trisilacyclohexane, 1,3,5,7-tetramethyl-1,3,5,7-tetrahydroxylcyclosiloxane, 1,1,4,4-tetramethyl-1,4-diethoxydisylethylene, 1,3,5-trimethyl-1,3,5-triethoxy-1,3,5-trisilacyclohexane, and a silane coupling agent having a functional group other than an amino group, such as an epoxy group or a mercapto group.

The composition may include a solvent other than a polar solvent. The solvent other than a polar solvent may be normal hexane, for example.

The composition may include benzotriazole or a derivative thereof for the purpose of suppressing corrosion of copper.

The pH of the composition is not particularly limited, and is preferably from 2.0 to 12.0.

When the pH of the composition is from 2.0 to 12.0, the composition is less prone to cause damage to a substrate.

The contents of sodium and potassium in the composition are preferably 10 ppb by mass or less on the basis of element, respectively. When the contents of sodium and potassium in the composition are 10 ppb by mass or less on the basis of element, electrical properties of semiconductor devices are less prone to cause troubles such as transistor malfunction.

When the composition includes a component other than the compound (A), compound (B) and compound (C), the total amount of the compound (A), compound (B) and compound (C) is preferably 50% by mass or more, more preferably 70% by mass or more, further preferably 80% by mass or more, with respect to the total amount of non-volatile components.

In the present disclosure, the non-volatile component refers to a component other than a component that is removed when the composition is cured, such as a solvent.

(Application of composition)

The application of the composition according to the present embodiment is not particularly limited, and the composition may be used for various purposes including production of semiconductor devices.

For example, the composition may be used for forming a layer on a substrate or between substrates, or may be used for producing a multilayer body as described later.

<Multilayer body>

The multilayer body according to the present embodiment is a multilayer body comprising a substrate and a layer, the layer (hereinafter also referred to as a "cured product layer") comprising a reaction product of:

a compound (A), having an Si-O bond and a cationic functional group that includes at least one selected from the group consisting of a primary nitrogen atom and a secondary nitrogen atom;
a compound (B), having at least three -C(=O)OX groups, wherein X is a hydrogen atom or an alkyl group with a carbon number of from 1 to 6, and from one to six of the -C(=O)OX groups is a -C(=O)OH group; and
a compound (C), having a cyclic structure and at least one primary nitrogen atom that is directly bonded to the cyclic structure,
the layer having a percentage of the primary nitrogen atom and the secondary nitrogen atom in the compound (A), with respect to a total amount of the primary nitrogen atom and the secondary nitrogen atom in the compound (A) and the primary nitrogen atom in the compound (C), of from 3 mol% to 95 mol%.

The details and preferred embodiments of the compound used as a starting material for a reaction product are

the same as the details and preferred embodiments of the compound included in the composition as previously mentioned. The layer including the reaction product may include a component that may be included in the composition, as necessary.

The cured product layer is disposed so as to face a surface of a substrate, and is bonded to the substrate, for example. As mentioned previously, the cured product layer obtained from the composition according to the present embodiment has a low thermal expansion coefficient. Therefore, a strain at a bonding interface between the cured product layer and the substrate, caused by a difference in thermal expansion coefficients thereof, is relatively small and the multilayer body exhibits excellent reliability.

The number of the substrate included in the multilayer body is not particularly limited, and may be one or more than one. When the multilayer body includes two or more substrates, the materials thereof may be the same or different from each other.

From the viewpoint of achieving the effect of the invention in an efficient manner, the substrate preferably has a thermal expansion coefficient that is equal to or less than a thermal expansion coefficient of the cured product layer.

In an embodiment of the multilayer body, the substrate includes a first substrate and a second substrate, and the first substrate, the cured product layer (a layer including a reaction product) and the second substrate are disposed in this order.

The material of the substrate may be an inorganic material, an organic material or a combination thereof, for example.

Specific examples of the inorganic material include semiconductors such as Si, InP, GaN, GaAs, InGaAs, InGaAlAs, SiGe and SiC; oxides, carbides or nitrides such as borosilicate glass (Pyrex, registered trade name), silica glass ($SiO_2$), sapphire ($Al_2O_3$), $ZrO_2$, $Si_3N_4$, AlN and $MgAl_2O_4$; piezoelectrics or dielectrics such as BaTiOs, $LiNbO_3$, $SrTiO_3$ and $LiTaO_3$; diamond; metals such as Al, Ti, Fe, Cu, Ag, Au, Pt, Pd, Ta and Nb; and carbon.

Specific examples of the organic material include polydimethylsiloxane (PDMS), epoxy resin, phenol resin, polyimide, benzocyclobutene resin and polybenzoxazole.

The major applications of these materials are as follows.

Si: semiconductor memories, LSI lamination, CMOS image sensors, MEMS sealing, optical devices and LEDs
$SiO_2$: semiconductor memories, LSI lamination, MEMS sealing, micro flow channels, CMOS image sensors, optical devices and LEDs
$BaTiO_3$, $LiNbO_3$, $SrTiO_3$ and $LiTaO_3$: surface acoustic wave devices
PDMS: micro flow channels
InGaAlAs, InGaAs and InP: optical devices
InGaAlAs, GaAs and GaN: LEDs

The substrate preferably has, at a surface thereof (at least at a surface that contacts a cured product layer), at least one selected from the group consisting of a hydroxy group, an epoxy group, a carboxy group, an amino group and a mercapto group. In that case, the bonding strength with respect to a cured product layer of the composition is further improved.

A surface having a hydroxy group may be obtained by performing a surface treatment such as a plasma treatment, a chemical treatment or an ozone treatment.

A surface having an epoxy group, a carboxy group, an amino group or a mercapto group may be obtained by performing a surface treatment with a silane coupling agent having an epoxy group, a carboxy group, an amino group or a mercapto group.

The at least one selected from the group consisting of a hydroxy group, an epoxy group, a carboxy group, an amino group and a mercapto group is preferably bonded to an element included in the substrate. The element is preferably at least one element selected from the group consisting of Al, Ti, Zr, Hf, Fe, Ni, Cu, Ag, Au, Ga, Ge, Sn, Pd, As, Pt, Mg, In, Ta and Ng. Further preferably, a silanol group (Si-OH) is formed from a hydorxy group and Si included in the substrate.

The substrate may have an electrode at at least one surface (preferably at a surface facing a cured product layer).

The thickness of the substrate is preferably from 1 $\mu$m to 1 mm, more preferably from 2 $\mu$m to 900 $\mu$m. When there are more than one substrate, the thickness of the substrate refers to a thickness of each one of the substrates. The thickness of the substrates may be the same or different from each other.

The shape of the substrate is not particularly limited. For example, when the substrate is a silicon substrate, the silicon substrate may have an interlayer insulation layer (Low-k film) formed thereon. The substrate may have fine grooves (concave portions), fine through holes, or the like.

The multilayer body may include a substrate that is not in contact with a cured product layer. The materials and other embodiments of the substrate that is not in contact with a cured product layer are the same as those of the substrate as previously mentioned.

The thickness of the cured product layer is not particularly limited, and may be determined depending on the purposes. For example, the thickness of the cured product layer may be any one of from 0.1 nm to 20000 nm, from 0.5

nm to 10000 nm, from 5 nm to 5000 nm, or from 5 nm to 3000 nm.

The cured product layer preferably has a content of an inorganic filler or a resin filler having a maximum particle diameter of 0.3 μm or more in the cured product layer of 30% by mass or less, more preferably 10% by mass or less, further preferably 0% by mass.

When the content of the filler in the cured product layer is within the above range, defective bonding may be suppressed even when a thickness of the cured product layer is reduced. In addition, there is a case in which alignment is performed with a machine to read alignment marks, which are given to a first substrate to which a cured product layer is formed and a second substrate, when layering the first substrate and the second substrate. When the content of the filler in the cured product layer is within the above range, transparency of the cured product layer is improved and the alignment may be performed in a precise manner.

The glass transition temperature (Tg) of the cured product layer is preferably from 100°C to 400°C. When the Tg is within the above range, the film after being subjected to a high-temperature process has a low elastic modulus, and therefore the warpage or internal stress in the multilayer body is reduced and a reduction in the bonding strength due to separation or the like is suppressed. The Tg is more preferably from 100°C to 350°C, further preferably from 120°C to 300°C, yet further preferably from 120°C to 250°C.

The Tg of the cured product layer is measured by the following method.

The composition is applied onto a resin film, and cured by baking for 1 hour under a nitrogen atmosphere at 350°C. A cured product layer with a thickness of 10 μm to 70 μm is obtained by removing the resin film.

The heat flow at from 23°C to 400°C (rate of temperature increase/decrease: 10°C/min) is measured with a differential scanning calorimeter (DSC) (TA Instruments, DSC2500) under a nitrogen atmosphere. The Tg of the cured product layer is determined by a temperature at an inflection point in the DSC curve.

The water absorption of the cured product layer is preferably 3% by mass or less. When the water absorption of the cured product layer is within the above range, the amount of outgas from the resin is effectively reduced, whereby occurrence of voids or separation in the multilayer body is effectively suppressed. The water absorption of the cured product layer is more preferably 2% by mass or less.

The water absorption of the cured product layer is measured by a method according to a standard method (ASTM D570) based on a difference in mass before and after the immersion of a cured product layer in pure water (23°C, 24 hours). The cured product layer used for the measurement is obtained in the same manner as the cured product layer used for the measurement of Tg.

The elastic modulus of the cured product layer at 250°C is preferably from 0.01 GPa to 20 GPa. When the elastic modulus of the cured product layer at 250°C is within the above range, the amount of internal stress during heating the multilayer body is reduced, whereby occurrence of warpage, separation or malfunction of a device layer may be suppressed. The elastic modulus of the cured product layer at 250°C is more preferably from 0.01 GPa to 12 GPa, further preferably from 0.1 GPa to 8 GPa.

The elastic modulus of the cured product layer at 250°C is measured using an atomic force microscope (AFM) by the following method.

A force curve of a cured product layer formed on a Si substrate is measured with an AFM (E-sweep, SII Nano Technology Inc., AFM force mapping mode, Si probe (spring constant: 2 N/m)) at a stage temperature of 250°C under vacuum. The measurement result is subjected to fitting with a DMT theory formula, thereby calculating the elastic modulus.

The DMT theory formula is shown below. In the formula, E represents an elastic modulus of a sample, v represents a Poisson ratio of a sample, R represents a tip diameter of cantilever, δ represents a depth of indentation, F represents a force applied to a sample, and Fc represents a maximum adhesion force. The Poisson ratio is assumed as 0.33.

$$E = \frac{3(1 - \nu^2)(F - F_c)}{4R^{\frac{1}{2}}\delta^{\frac{3}{2}}}$$

The hardness of the cured product layer at room temperature (23°C) is preferably from 0.05 GPa to 1.8 GPa. When the hardness of the cured product layer is within the above range, cracking of a film when an external force is applied to the multilayer body during a process such as wire bonding may be suppressed. The hardness of the cured product layer at room temperature (23°C) is more preferably from 0.2 GPa to 1.5 GPa, further preferably from 0.3 GPa to 1.0 GPa.

The hardness of the cured product layer is measured by a method according to ISO 14577 (nano-indentation).

Specifically, an unloading-displacement curve at 23°C of a cured product layer formed on a silicon substrate is measured with a nano-indenter (Berkovich indenter) at a depth of indentation of 20 nm. According to a method described in Handbook of Micro/nano Tribology (second Edition), edited by Bharat Bhushan, CRR Press, LLC), the hardness of the cured product layer at 23°C is calculated from the maximum load. The hardness (H) is defined by the following formula. In the formula, Pmax represents a maximum load at a depth of indentation of 20 nm, and Ac represents a projected area of the indenter against a sample at a depth of indentation of 20 nm.

$$H = \frac{P_{max}}{A_c}$$

The elastic modulus of the cured product layer at room temperature (23°C) is preferably from 0.1 GPa to 20 GPa. When the elastic modulus of the cured product layer at room temperature is within the above range, warpage or separation of a layer caused by application of an external force such as compression or shearing to the multilayer body may be suppressed. The elastic modulus of the cured product layer at room temperature is more preferably from 0.5 GPa to 15 GPa, further preferably from 1 GPa to 10 GPa.

The elastic modulus of the cured product layer at room temperature is measured by the following method.

An unloading-displacement curve at 23°C of a cured product layer formed on a silicon substrate is measured with a nano-indenter (Berkovich indenter) at a depth of indentation of 20 nm. According to a method described in Handbook of Micro/nano Tribology (second Edition), edited by Bharat Bhushan, CRR Press, LLC), the elastic modulus at 23°C is calculated from the maximum load and maximum displacement.

The elastic modulus is defined by the following formula. In the formula, $E_r$ represents an elastic modulus of a sample, $E_i$ represents a Young's modulus of the indenter (1140 GPa), $\nu_i$ represents a Poisson ratio of the indenter (0.07), $E_s$ represents a Young's modulus of a sample, and $\nu_s$ represents a Poisson ratio of a sample.

$$\frac{1}{E_r} = \frac{1-\nu_i^2}{E_i} + \frac{1-\nu_s^2}{E_s}$$

(Exemplary configurations of multilayer body)

The multilayer body may be used for various purposes, including components of semiconductor devices. The following are exemplary configurations of the multilayer body.

MEMS packaging: Si/cured product layer/Si, $SiO_2$/cured product layer/Si, $SiO_2$/cured product layer/ $SiO_2$ and Cu/cured product layer/Cu
Micro flow channels: PDMS/cured product layer/PDMS and PDMS/cured product layer/ $SiO_2$
CMOS image sensors: $SiO_2$/cured product layer/$SiO_2$, Si/cured product layer/Si and $SiO_2$/cured product layer/Si
Through-silicon via (TSV): $SiO_2$ (with Cu electrode)/cured product layer/$SiO_2$ (with Cu electrode)
Memories and LSIs: $SiO_2$/cured product layer/$SiO_2$
Optical devices: (InGaAlAs, InGaAs, InP or GaAs)/cured product layer/Si
LEDs: (InGaAlAs, GaAs or GaN)/cured product layer/Si, (InGaAlAs, GaAs or GaN)/cured product layer/$SiO_2$, (InGaAlAs, GaAs or GaN)/cured product layer/(Cu, Ag or Al) and (InGaAlAs, GaAs or GaN)/cured product layer/sapphire
Surface acoustic wave devices: ($BaTiO_3$, $LiNbO_3$, $SrTiO_3$ or $LiTaO_3$)/cured product layer/($MgAl_2O_4$, $SiO_2$, Si or $Al_2O_3$)

The multilayer body may have a cured product that is formed as an insulation film at a position such as a surface of a substrate, a concave portion formed at a surface of a substrate, or a through hole, in addition to a multilayer structure as previously mentioned.

The cured product layer may be formed for temporal purposes. For example, the cured product layer may be formed on a substrate as a sacrificing layer, which is removed at a later process during the production of semiconductor

devices.

The tensile bonding strength of the multilayer body is preferably as high as possible, from the viewpoint of suppressing the unintended separation and ensuring the reliability of the multilayer body. Specifically, the tensile bonding strength of the multilayer body is preferably 5 MPa or more, more preferably 10 MPa or more. The tensile bonding strength of the multilayer body may be calculated from a yield point obtained by a measurement using a tensile tester. The tensile bonding strength may be 200 MPa or less, or may be 100 MPa or less.

From the viewpoint of suppressing a decrease in the bonding strength due to outgassing, the multilayer body preferably has a temperature at which a pressure of outgassing is $2\times10^{-6}$ Pa of 400°C or more, more preferably 420°C or more, further preferably 440°C or more. The temperature at which a pressure of outgassing is $2\times10^{-6}$ Pa is a value measured under reduced pressure ($1\times10^{-7}$ Pa). The temperature at which a pressure of outgassing is $2\times10^{-6}$ Pa may be 600°C or less, or may be 550°C or less.

The multilayer body preferably has a percentage of area of total voids (void area ratio) of 30% or less, more preferably 20% or less, further preferably 10% or less.

The void area ratio is measured by infrared transmission observation. The void area ratio is a value obtained by dividing a total area of voids by a total area at which transmitted light is observed, and multiplying the quotient by 100.

When it is difficult to perform infrared transmission observation, the void area ratio may be measured in a similar manner by ultrasonic microscopy using reflective waves, transmitted waves or infrared reflective waves, preferably reflective waves.

The bonding strength of the multilayer body is preferably as high as possible from the viewpoint of suppressing the unintended separation or ensuring the reliability of the multilayer body. Specifically, the multilayer body preferably has a bonding strength represented by a surface energy of 0.2 $J/m^2$ or more, more preferably 0.5 $J/m^2$ or more, further preferably 1.0 $J/m^2$ or more, yet further preferably 2.5 $J/m^2$ or more.

When the multilayer body includes a first substrate and a second substrate, the bonding strength represented by a surface energy between the first and second substrates is preferably within the above range. The surface energy of the multilayer body is measured by a blade insert test as described later.

<Method for producing multilayer body>

The method for producing a multilayer body according to the present embodiment is a method for producing a multilayer body, the method comprising a first step for forming a layer on a substrate or between substrates and a second step for curing the layer, the layer comprising:

a compound (A), having an Si-O bond and a cationic functional group that includes at least one selected from the group consisting of a primary nitrogen atom and a secondary nitrogen atom;
a compound (B), having at least three -C(=O)OX groups, wherein X is a hydrogen atom or an alkyl group with a carbon number of from 1 to 6, and from one to six of the -C(=O)OX groups is a -C(=O)OH group; and
a compound (C), having a cyclic structure and at least one primary nitrogen atom that is directly bonded to the cyclic structure,
the layer having a percentage of the primary nitrogen atom and the secondary nitrogen atom in the compound (A), with respect to a total amount of the primary nitrogen atom and the secondary nitrogen atom in the compound (A) and the primary nitrogen atom in the compound (C), of from 3 mol% to 95 mol%.

The details and preferred embodiments of the substrate and the compound used in the method are the same as the details and preferred embodiments of the substrate and the compound as previously mentioned.

(First process)

The first process may be performed by any method. For example, a layer may be formed by applying the compound (A), compound (B) and compound (C) onto a substrate or between substrate in a single process (i.e., use the composition as previously mentioned), or may be formed by applying the compound (A), compound (B) and compound (C) separately in plural processes.

When the compound (A), compound (B) and compound (C) are applied onto a substrate or between substrates in plural processes, the compounds may be applied in any order. It is possible to apply each of the compounds separately, or any two of the compounds at the same time.

When the compound (A), compound (B) and compound (C) are applied onto a substrate or between substrates in plural processes, each process may be followed by drying, washing or the like, as necessary.

From the viewpoint of forming a layer having a uniform thickness onto a substrate or between substrates, the compound (A), compound (B) and compound (C) are preferably in a state of a solution. The solution may be prepared

by using a solvent that may be included in the composition as previously mentioned.

The layer including the compound (A), compound (B) and compound (C) may be formed by any method. Examples of the method include dipping, spraying, spin coating and bar coating. Among these methods, bar coating is preferred in a case of forming a layer with a micrometer-scale thickness, and spin coating is preferred in a case of forming a layer with a nanometer-scale thickness (for example, from several nanometers to several-hundred nanometers).

The method for forming a layer by spin coating is not particularly limited. For example, a layer may be formed by dropping a solution onto a substrate being rotated by a spin coater, and then drying the solution by increasing the number of rotation of the substrate. The conditions for spin coating such as the number of rotation of a substrate, the amount or time for dropping a solution, or the number of rotation of a substrate during a drying process are not particularly limited, and may be adjusted in view of the thickness of a layer to be formed, and the like.

(Second process)

In the second process, a layer including the compound (A), compound (B) and compound (C) is cured. More specifically, a layer including a reaction product of the compounds (cured product layer) is formed by causing the compounds to react.

The reaction of the compound (A), compound (B) and compound (C) may be caused by heating the compounds at a temperature at which the reaction of compounds is caused (for example, 70°C to 450°C).

The temperature is preferably from 100°C to 450°C, more preferably from 100°C to 400°C, further preferably from 150°C to 350°C. The temperature may be any one of from 70°C to 280°C, from 80°C to 250°C, or from 90°C to 2000°C.

The pressure during the heating is not particularly limited. For example, the heating may be performed under a condition of higher than an absolute pressure (17 Pa) but not higher than an atmospheric pressure. The pressure is preferably from 1000 Pa to an atmospheric pressure, more preferably from 5000 Pa to an atmospheric pressure, further preferably from 10000 Pa to an atmospheric pressure.

The method for the heating is not particularly limited, and may be an ordinary method using a furnace or a hot plate. Examples of the furnace include SPX-1120 (Appex Corporation) and VF-1000LP (JTEKT Thermo Systems Corporation).

The heating may be performed under an atmospheric environment or an inert gas environment such as nitrogen, argon or helium.

The time for the heating is not particularly limited. For example, the time for the heating may be 3 hours or less or 1 hour or less.

The lower limit for the time for the heating is not particularly limited. For example, the time for the heating may be 30 seconds or more, 3 minutes or more, or 5 minutes or more.

When the heating is performed at from 70°C to 250°C, the time for the heating may be any one of 300 seconds or less, 200 seconds or less, 120 seconds or less or 80 seconds or less, and the time for the heating may be any one of 10 seconds or more, 20 seconds or more or 30 seconds or more.

The temperature for the heating may be constant or not constant. For example, the heating may include a process of heating at low temperature (70°C to 250°C) and a process of heating at higher temperature (100°C to 450°C).

In order to reduce the time for the heating, the compound (A), compound (B) and compound (C) that have been applied onto a substrate may be exposed to ultraviolet light. Examples of the ultraviolet light include ultraviolet light at a wavelength of from 170 nm to 230 nm, excimer light at a wavelength of 222 nm, and excimer light at a wavelength of 172 nm. The exposure is preferably performed in an inert gas atmosphere.

(Pressurizing process)

The multilayer body is preferably pressurized at the second process (heating) or after the second process (heating). By pressurizing the multilayer body, an area at which the substrate and the cured product layer are in contact with each other is increased, thereby the bonding strength tends to be improved.

When the pressurization is performed while heating the multilayer body, the pressure to be applied to the multilayer body is preferably from 0.1 MPa to 50 MPa, more preferably from 0.1 MPa to 10 MPa, further preferably from 0.1 MPa to 5 MPa. The pressurization may be performed by a press machine such as TEST MINI PRESS (Toyo Seiki Seisaku-sho, Ltd.)

When the pressurization is performed while heating the multilayer body, the pressurization is performed preferably at from 100°C to 450°C, more preferably from 100°C to 400°C, further preferably from 150°C to 350°C. When the temperature is within the above range, semiconductor circuits formed on a substrate are less likely to be damaged.

When the pressurization is performed after heating the multilayer body, the pressure to be applied to the multilayer body is preferably from 0.1 MPa to 50 MPa, more preferably from 0.1 MPa to 10 MPa. The pressurization may be performed by a press machine such as TEST MINI PRESS (Toyo Seiki Seisaku-sho, Ltd.) The time for the

pressurizing is not particularly limited, and may be from 0.5 seconds to 1 hour, for example.

When pressurization is performed after heating the multilayer body, the pressurization is performed preferably at from 10°C to less than 100°C, more preferably from 10°C to 70°C, further preferably from 15°C to 50°C, yet further preferably from 20°C to 30°C. The temperature refers to a temperature at a surface of a substrate at which the compound (A), compound (B) and compound (C) are applied.

(Post-heating process)

The method for producing a multilayer body may include a post-heating process, in which the multilayer body is further heated after the second process. By performing a post-heating process, the bonding strength tends to be further improved.

The temperature for the post-heating process is preferably from 100°C to 450°C, more preferably from 150°C to 420°C, further preferably from 150°C to 400°C.

The pressure at which the post-heating is performed may be higher than an absolute pressure (17Pa) but not higher than an atmospheric pressure. The pressure is preferably from 1000 Pa to an atmospheric pressure, more preferably from 5000 Pa to an atmospheric pressure, further preferably from 10000 Pa to an atmospheric pressure.

In the post-heating process, the multilayer body is preferably not pressurized.

[Examples]

In the following, the present invention is explained in a more specific manner by referring the Examples. However, the present invention is not limited to the Examples.

(Preparation of composition)

Compositions for the Examples and the Comparative Examples including the components shown in Table 1 were prepared.

The amount of the components were adjusted such that the amine equivalent amount of the compound (A) and the compound (C) in total was equal to the carboxy group equivalent amount of the compound (C), and that the percentage of the primary nitrogen atom and the secondary nitrogen atom in the compound (A), with respect to a total amount of the primary nitrogen atom and the secondary nitrogen atom in the compound (A) and the primary nitrogen atom in the compound (C), was a value (mol%) shown in Table 1. The percentage (% by mass) described in the compound (A) refers to a value with respect to the compound (A).

Each composition includes water, ethanol and N,N-dimethylacetamide as a polar solvent.

Table 1

| | Examples | | | | | | | | Comparative Examples | | |
|---|---|---|---|---|---|---|---|---|---|---|---|
| | 1 | 2 | 3 | 4 | 5 | 6 | 7 | 8 | 1 | 2 | 3 |
| Compound (A) | 3APDES | 3APDES | 3APDES | 3APDES | 3APDES | 3APDES (90 mass%)/ M3TMSPA (10 mass%) | 3APDES (80 mass%)/ APTES (20 mass%) | 3APDES | 3APDES | 3APDES | - |
| Compound (B) | ODPA | BPDA | ODPA | PMDA | ODPA | ODPA | ODPA | ODPA | ODPA | ODPA | ODPA |
| Compound (C) | TFDB | AAPD | AAPD | AAPD | TFDB | TFDB | TFDB | TFDB | - | pXDA | AAPD |
| Percentage of primary secondary nitrogen atoms in Compound (A) [mol%] | 20 | 10 | 20 | 95 | 3 | 20 | 40 | 40 | 100 | 20 | 0 |
| Surface energy [J/m$^2$] | over 2.5 | over 2.5 | over 2.5 | over 2.5 | 0.48 | over 2.5 | over 2.5 | over 2.5 | over 2.5 | over 2.5 | below 0.1 |
| CTE [ppm/°C] | 77 | 26 | 44 | 97 | 56 | 76 | 83 | 95 | 145 | 125 | 38 |

The details of the components shown in Table 1 are as follows.

3APDES: 3-aminopropyldiethoxymethylsilane
3APTES: 3-aminopropyltriethoxysilane
M3TEMSPA: N-methyl-3-(trimethoxysilyl)propylamine
ODPA: half-esterified compound obtained by ring-opening of 4,4'-oxydiphthalic anhydride with ethanol
BPDA: half-esterified compound obtained by ring-opening of 4,4'-biphenyltetracarboxylic dianhydride with ethanol
PMDA: half-esterified compound obtained by ring-opening of pyromellitic dianhydride with ethanol
TFDB: 4,4'-diamino-2,2'-bis(trifluoromethyl)biphenyl
AAPD: 4,4'-diamino-2,2'-dimethylbiphenyl
pXDA: p-xylylenediamine

(Evaluation of bonding strength)

The composition was applied onto a silicon substrate (substrate 1) by spin coating, and a different silicon substrate (substrate 2) was disposed thereon. The composition was cured by heating at 250°C while applying a pressure of 1 MPa, thereby obtaining a multilayer body having a cured product layer between the substrate 1 and the substrate 2.
The multilayer body was subjected to a blade insert test to measure a surface energy at an interface between the substrate and the cured product layer, by a method according to Journal of Applied Physics, 64 (1988) 4943-4950.
Specifically, a blade with a thickness of 0.25 mm was inserted between the substrate 1 and the substrate 2, and a distance from a tip of the blade to a position at which the substrates separate from each other was measured using an infrared light source and an infrared camera. The surface energy was calculated by the following formula. The greater the surface energy is, the greater the bonding strength of the cured product layer with respect to the substrate is. When the surface energy is 0.2 J/m$^2$ or more, the bonding strength is regarded as acceptable. The results are shown in Table 1.

$$\gamma=3\times10^9\times t_b^2\times E^2\times t^6/(32\times L^4\times E\times t^3)$$

In the formula, $\gamma$ represents a surface energy (J/m$^2$), $t_b$ represents a thickness of blade (m), E represents a Young's modulus of substrate 1 and substrate 2 (GPa), t represents a total thickness of substrate 1 and substrate 2 (m), and L represents a distance from a tip of blade to a position at which substrate 1 and substrate 2 separate from each other.

(Evaluation of thermal expansion coefficient)

The composition was applied onto a polyimide film (UPILEX, UBE Corporation) by spin coating, and the composition was cured at 350°C to form a cured product layer.
After separating the polyimide film, an average linear expansion coefficient (CTE) of the cured product layer was measured using a thermomechanical analyzer (TMA 7100C, Hitachi High-Tech Science Corporation) in a nitrogen atmosphere at 250°C. The smaller the CTE is, the smaller the thermal expansion coefficient of the cured product layer is. The results are shown in Table 1.
As shown in Table 1, the Examples using the composition according to the present embodiment exhibit a smaller CTE of a cured product layer than Comparative Example1, in which the composition does not include compound (C), or Comparative Example 2, in which the composition includes a diamine compound not having an amino group directly bonded to a cyclic structure instead of compound (C). The results indicate that the Examples achieve a lower thermal expansion coefficient than the Comparative Examples.
Further, the Examples exhibit a greater surface energy than Comparative Example 3, in which the composition does not include compound (A), indicating that the Examples achieve a better bonding strength than Comparative Example 3.
The disclosure of Japanese Patent Application No. 2020-152329 is incorporated herein by reference in its entirety.
All publications, patent applications, and technical standards mentioned in the present specification are incorporated herein by reference to the same extent as if each individual publication, patent application, or technical standard was specifically and individually indicated to be incorporated by reference.

## Claims

1. A composition, comprising:

   a compound (A), having an Si-O bond and a cationic functional group that includes at least one selected from the group consisting of a primary nitrogen atom and a secondary nitrogen atom;
   a compound (B), having at least three -C(=O)OX groups, wherein X is a hydrogen atom or an alkyl group with a carbon number of from 1 to 6, and from one to six of the -C(=O)OX groups is a -C(=O)OH group; and
   a compound (C), having a cyclic structure and at least one primary nitrogen atom that is directly bonded to the cyclic structure,
   the composition having a percentage of the primary nitrogen atom and the secondary nitrogen atom in the compound (A), with respect to a total amount of the primary nitrogen atom and the secondary nitrogen atom in the compound (A) and the primary nitrogen atom in the compound (C), of from 3 mol% to 95 mol%.

2. The composition according to claim 1, wherein the compound (C) has two or more primary nitrogen atoms that are directly bonded to the cyclic structure.

3. The composition according to claim 1 or 2, wherein the compound (C) has a weight average molecular weight of from 80 to 600.

4. The composition according to any one of claims 1 to 3, wherein the compound (A) has two alkyl groups that are bonded to an oxygen atom in the Si-O bond.

5. The composition according to any one of claims 1 to 4, wherein the compound (B) has a weight average molecular weight of from 200 to 600.

6. The composition according to any one of claims 1 to 5, further comprising a polar solvent.

7. The composition according to any one of claims 1 to 6, which is used for producing a semiconductor device.

8. The composition according to any one of claims 1 to 7, which is used for forming a layer on a substrate or between substrates.

9. A multilayer body comprising a substrate and a layer, the layer comprising a reaction product of:

   a compound (A), having an Si-O bond and a cationic functional group that includes at least one selected from the group consisting of a primary nitrogen atom and a secondary nitrogen atom;
   a compound (B), having at least three -C(=O)OX groups, wherein X is a hydrogen atom or an alkyl group with a carbon number of from 1 to 6, and from one to six of the -C(=O)OX groups is a -C(=O)OH group; and
   a compound (C), having a cyclic structure and at least one primary nitrogen atom that is directly bonded to the cyclic structure,
   the layer having a percentage of the primary nitrogen atom and the secondary nitrogen atom in the compound (A), with respect to a total amount of the primary nitrogen atom and the secondary nitrogen atom in the compound (A) and the primary nitrogen atom in the compound (C), of from 3 mol% to 95 mol%.

10. The multilayer body according to claim 9, wherein the substrate comprises a first substrate and a second substrate, and the first substrate, the layer comprising the reaction product, and the second substrate are disposed in this order.

11. A method for producing a multilayer body, the method comprising forming a layer on a substrate or between substrates and curing the layer, the layer comprising:

    a compound (A), having an Si-O bond and a cationic functional group that includes at least one selected from the group consisting of a primary nitrogen atom and a secondary nitrogen atom;
    a compound (B), having at least three -C(=O)OX groups, wherein X is a hydrogen atom or an alkyl group with a carbon number of from 1 to 6, and from one to six of the -C(=O)OX groups is a -C(=O)OH group; and
    a compound (C), having a cyclic structure and at least one primary nitrogen atom that is directly bonded to the cyclic structure,
    the layer having a percentage of the primary nitrogen atom and the secondary nitrogen atom in the compound

(A), with respect to a total amount of the primary nitrogen atom and the secondary nitrogen atom in the compound (A) and the primary nitrogen atom in the compound (C), of from 3 mol% to 95 mol%.

**INTERNATIONAL SEARCH REPORT**

International application No.
**PCT/JP2021/033032**

**A. CLASSIFICATION OF SUBJECT MATTER**

***H01L 25/065***(2006.01)i; ***H01L 25/07***(2006.01)i; ***H01L 25/18***(2006.01)i; ***H01L 21/312***(2006.01)i
FI: H01L21/312 C; H01L25/08 Y

According to International Patent Classification (IPC) or to both national classification and IPC

**B. FIELDS SEARCHED**

Minimum documentation searched (classification system followed by classification symbols)

H01L25/065; H01L25/07; H01L25/18; H01L21/312

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 06-308731 A (CHISSO CORP.) 04 November 1994 (1994-11-04) paragraphs [0034], [0043]-[0046], [0053] | 1-9, 11<br>8, 10, 11 |
| Y | WO 2020/085183 A1 (MITSUI CHEMICALS INC.) 30 April 2020 (2020-04-30) paragraphs [0013]-[0015], [0029]-[0092] | 8, 10, 11 |
| A | WO 2017/086361 A1 (MITSUI CHEMICALS INC.) 26 May 2017 (2017-05-26) entire text, all drawings | 1-11 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **09 November 2021** | **22 November 2021** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2021/033032**

| Patent document cited in search report | Publication date (day/month/year) | Patent family member(s) | Publication date (day/month/year) |
|---|---|---|---|
| JP 06-308731 A | 04 November 1994 | US 6664021 B1<br>column 10, line 48 to column 11, line 5, column 12, lines 63 to column 14, line 3, column 15, lines 25-55<br>GB 2275475 A<br>DE 4406282 A1<br>KR 10-1994-0020178 A<br>TW 269730 B | |
| WO 2020/085183 A1 | 30 April 2020 | EP 3855477 A1<br>paragraphs [0012]-[0015], [0035]-[0112]<br>CN 112889131 A<br>KR 10-2021-0060571 A<br>TW 202037700 A | |
| WO 2017/086361 A1 | 26 May 2017 | US 2018/0334588 A1<br>entire text, all drawings<br>EP 3379565 A1<br>KR 10-2018-0071300 A<br>CN 108352320 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H04132258 A
- JP 2010226060 A
- JP 2016047895 A
- JP 2020152329 A


### Non-patent literature cited in the description


- **A. BAYRASHEV ; B. ZIAIE.** *Sensors and Actuators A,* 2003, vol. 103, 16-22
- **Q. Y. TONG ; U. M. GOSELE.** *Advanced Material,* 1999, vol. 11 (17), 1409-1425
- Handbook of Micro/nano Tribology. CRR Press, LLC
- *Journal of Applied Physics,* 1988, vol. 64, 4943-4950